# DEMANDE DE BREVET EUROPEEN

(11) **EP 1 191 794 A1**
(43) Date de publication de la demande: **27.03.2002**
(21) Numéro de dépôt: 01203179.5
(22) Date de dépôt: 23.08.2001
(51) Int. Cl.: H04N 7/26, H03M 7/40

(54) **Traitement de données en une série temporelle d'étapes**

(30) Priorité: 31.08.2000 FR 0011145
(71) Demandeur: Koninklijke Philips Electronics N.V., 5621 BA Eindhoven (NL)
(72) Inventeur: Gobert, Jean, 75008 Paris (FR); Dombek, Thomas, 75008 Paris (FR)
(74) Mandataire: Chaffraix, Jean

(57) **Abrégé**

Un traitement de données est effectué en une série temporelle d'étapes de traitement [S]. Une étape de traitement [S(n)] génère un résultat [O(n)] à partir d'un ensemble de résultats [O(n-1), O(n-2), ...,O(n-m)] de certaines étapes de traitement précédentes [S(n-1), S(n-2), ..., S(n-m)]. Le décodage arithmétique contextuel qui fait partie de la norme MPEG4, est un exemple d'un tel traitement de données.

Les caractéristiques suivantes permettent des implémentations à relativement faible coût. Une étape de traitement [S] est effectuée en deux sous-étapes: une sous-étape de préparation [SA] et une sous-étape de finition [SB]. Dans la sous-étape de préparation [SA], un résultat intermédiaire [I] est établie à partir d'un ensemble incomplet de résultats dans lequel il manque, par rapport à l'ensemble de résultats à partir duquel le résultat doit être calculé, au moins le résultat de l'étape de traitement précédente la plus proche. Dans la sous-étape de finition [SB], le résultat [O] est établi à partir du résultat intermédiaire [I] et du résultat de l'étape de traitement précédente la plus proche et des autres résultats qui manquaient dans l'ensemble incomplet de résultats, s'il y en a.

## Description

### DOMAINE TECHNIQUE

L'invention concerne un traitement de données en une série temporelle d'étapes. L'invention peut-être appliquée, par exemple, pour effectuer un décodage de forme selon la norme MPEG4. (MPEG est l'abréviation pour le terme anglais Moving Picture Expert Group.)

### ETAT DE LA TECHNIQUE ANTERIEURE

Une étape de traitement peut typiquement générer un résultat à partir d'un ensemble de résultats de certaines étapes de traitement précédentes. Par exemple, une étape de traitement numéro K peut consister à calculer un résultat à partir des résultats des trois étapes de traitement précédentes les plus proches: les étapes numérotées K-1, K-2 et K-3, K étant un entier supérieur à 3. Dans un tel traitement de données, chaque étape de traitement fournit un nouveau résultat. En effet, c'est comme s'il existait un panier de résultats qui se remplit graduellement en effectuant les étapes de traitements. Chaque étape de traitement considère certains résultats déjà présents dans le panier pour en ajouter un autre. C'est un processus de croissance graduelle. Un exemple d'un tel traitement de données est le décodage arithmétique contextuel selon la norme MPEG4.

### EXPOSE DE L'INVENTION

Un but de l'invention est de permettre des implémentations à relativement faible coût.

Selon l'invention, un traitement de données est caractérisé comme suit. Le traitement de données est effectué en une série temporelle d'étapes de traitement. Une étape de traitement génère un résultat à partir d'un ensemble de résultats de certaines étapes de traitement précédentes. Une étape de traitement est effectuée en deux sous-étapes: une sous-étape de préparation et une sous-étape de finition. Dans la sous-étape de préparation, un résultat intermédiaire est établi à partir d'un ensemble incomplet de résultats dans lequel il manque, par rapport à l'ensemble de résultats à partir duquel le résultat doit être calculé, au moins le résultat de l'étape de traitement précédente la plus proche. Dans la sous-étape de finition, le résultat est établi à partir du résultat intermédiaire et du résultat de l'étape de traitement précédente la plus proche et des autres résultats qui manquaient dans l'ensemble incomplet de résultats, s'il y en a.

L'invention prend les aspects suivants en considération. Une étape de traitement ne peut produire un résultat que si les étapes précédentes ont déjà été effectuées. Par exemple, supposons qu'une étape de traitement numéro K consiste à calculer un résultat à partir des résultats des étapes de traitement précédentes numérotées K-1, K-2 et K-3. Le résultat de l'étape de traitement numéro K-1 doit donc être disponible pour calculer le résultat de l'étape de traitement numéro K. Si l'on attend que l'étape de traitement K-1 soit achevée avant de commencer à effectuer l'étape de traitement numéro K, il n'y aura pas de problème. Donc, le plus simple et logique paraît d'effectuer les étapes de traitement séquentiellement.

En général, un traitement de données doit être effectué dans un certain délai. Par exemple, dans un système de décodage MPEG-4 pour affichage en temps réel, le décodage de forme doit être achevé avant certaines étapes ultérieures de décodage de texture et l'affichage de l'image. En principe, il est possible d'effectuer un traitement de données dans le délai souhaité en utilisant des circuits suffisamment rapides. Par exemple, supposons que Tmax soit le délai dans lequel une série de N étapes de traitement doit être effectuée, N étant un entier. Si les étapes de traitements sont effectuées séquentiellement, les circuits utilisés doivent effectuer une étape de traitement dans un délai Tmax divisé par N. Si le délai Tmax est relativement court et N est relativement large, les circuits devront être relativement rapides. Tel est le cas, par exemple, dans le décodage de forme selon la norme MPEG4.

Selon l'invention, une étape de traitement est effectuée en deux sous-étapes: la sous-étape de préparation et la sous-étape de finition décrites précédemment. La sous-étape de préparation d'une certaine étape de traitement ne dépend pas de l'étape de traitement précédente. Par conséquent, la sous-étape de préparation d'une certaine étape de traitement peut être effectuée en parallèle avec la sous-étape de finition de l'étape de traitement précédente. Donc, l'invention permet un parallélisme dans l'exécution des étapes de traitement: à un instant donné, il est possible de travailler sur plusieurs étapes de traitement. Par conséquent, étant donné un délai pour l'exécution d'une série d'étapes de traitement, on dispose de plus de temps pour effectuer une étape de traitement selon l'invention par rapport à une implémentation où l'on effectuerait les étapes de traitement séquentiellement. Par conséquent, l'invention permet des implémentations utilisant des circuits moins rapides. En général, il est vrai que moins un circuit est rapide, moins le circuit est coûteux. Par conséquent, l'invention permet des implémentations à relativement faible coût.

Ces aspects de l'invention ainsi que d'autres aspects seront décrits plus en détail en référence aux Figures suivantes.

### BREVE DESCRIPTION DES FIGURES

La Figure 1 est un diagramme conceptuel illustrant des caractéristiques de base décrites précédemment;

La Figure 2 est un diagramme conceptuel illustrant un contexte pour l'encodage et décodage arithmétique contextuel faisant partie de la norme MPEG4.

La Figure 3 est un diagramme de bloc illustrant un dispositif de traitement de données MPEG4.

La Figure 4 est un organigramme illustrant l'opération d'un processeur de préparation.

La Figure 5 est un organigramme illustrant l'opération d'un processeur de finition.

### MODES DE REALISATION DE L'INVENTION

Les remarques suivantes concernent les signes de référence. Des entités similaires sont désignées par une référence par lettres identique dans toutes les figures. Plusieurs entités similaires peuvent apparaître dans une seule figure. Dans ce cas, un chiffre ou un suffixe est ajouté à la référence par lettres afin de distinguer des entités similaires. Le chiffre ou le suffixe peut être omis pour des raisons de convenance. Ceci s'applique pour la description ainsi que pour les revendications.

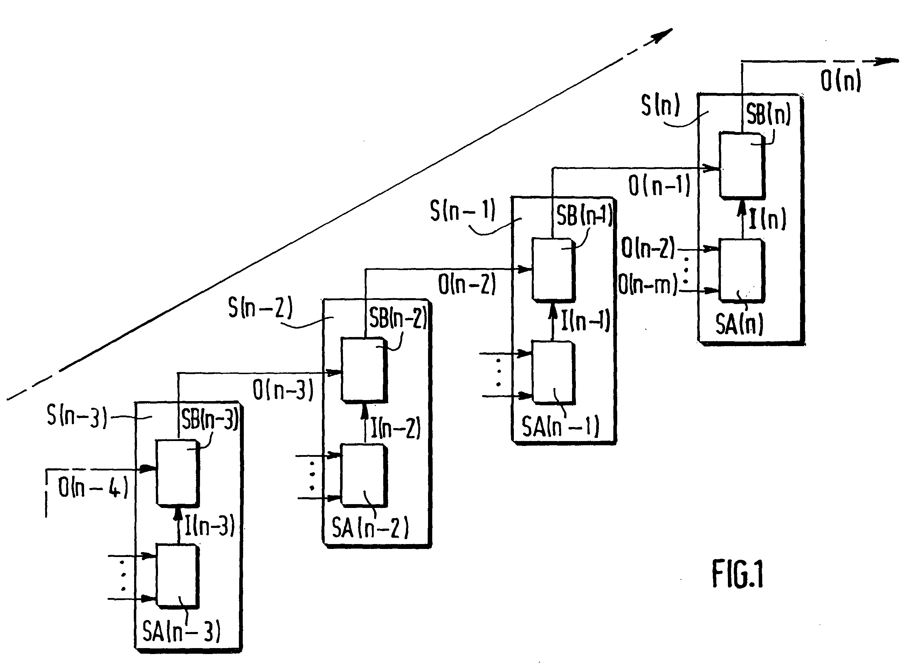

La Figure 1 illustre des caractéristiques de base décrites précédemment. Un traitement de données est effectué en une série temporelle d'étapes de traitement [S]. Une étape de traitement [S(n)] génère un résultat [O(n)] à partir d'un ensemble de résultats [O(n-1), O(n-2), ...,O(n-m)] de certaines étapes de traitement précédentes [S(n-1), S(n-2), ..., S(n-m)]. Une étape de traitement [S] est effectuée en deux sous-étapes: une sous-étape de préparation [SA] et une sous-étape de finition [SB]. Dans la sous-étape de préparation [SA] un résultat intermédiaire [I] est établi à partir d'un ensemble incomplet de résultats dans lequel il manque, par rapport à l'ensemble de résultats à partir duquel le résultat doit être calculé, au moins le résultat de l'étape de traitement précédente la plus proche. Dans la sous-étape de finition [SB] le résultat [O] est établi à partir du résultat intermédiaire [I] et du résultat de l'étape de traitement précédente la plus proche et des autres résultats qui manquaient dans l'ensemble incomplet de résultats, s'il y en a.

Les caractéristiques illustrées à la Figure 1 peuvent être appliquées, par exemple, pour effectuer un décodage de forme selon la norme MPEG 4. Le décodage de forme consiste à établir un ensemble de valeurs booléennes associé à un ensemble de pixels représentant un certain objet. Il y a une valeur booléenne pour chaque pixel. La valeur booléenne indique si le pixel concerné appartient à l'objet ou non. Au niveau de l'encodage de forme, l'ensemble de pixels est en effet reparti en blocs de pixels. Chaque bloc de pixels fait l'objet d'un encodage de forme selon un certain mode parmi plusieurs modes d'encodage de forme possibles. Un mode d'encodage de forme correspond à un encodage arithmétique contextuel. Il en résulte un code arithmétique pour le bloc de pixels concerné.

Le décodage arithmétique contextuel consiste à établir successivement une valeur booléenne pour chaque pixel du bloc de la façon suivante. D'abord un contexte est établi pour le pixel concerné. Le contexte est constitué de certaines valeurs booléennes déjà obtenues pour d'autres pixels. La norme définit pour chaque pixel du bloc, les pixels dont les valeurs booléennes sont à prendre en compte. Ensuite, une probabilité est établie à partir du contexte. La norme définit une probabilité pour chaque contexte possible. Finalement, la valeur booléenne est établie à partir de la probabilité et du code arithmétique appartenant au bloc de pixels concerné. Cette dernière phase constitue le coeur du décodage arithmétique contextuel. Donc, on pourrait dire que le décodage arithmétique contextuel comprend trois phases pour chaque pixel: une phase "contexte", une phase "probabilité" et une phase "décodage".

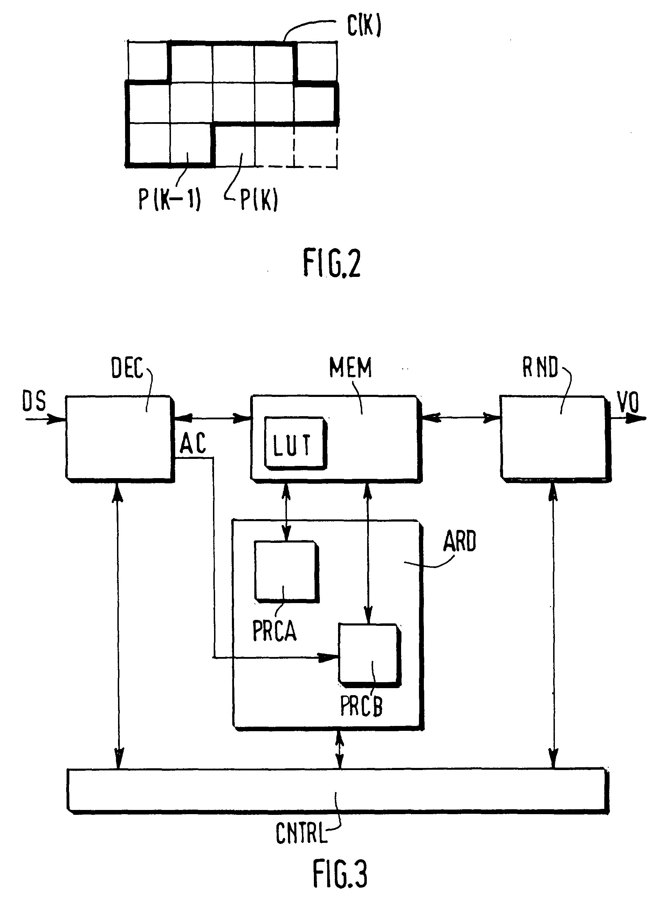

La Figure 2 illustre un contexte [C(K)] pour l'établissement d'une valeur booléenne appartenant au pixel [P(K)]. Chaque carré représente à la fois un pixel et la valeur booléenne qui lui appartient. Il est supposé que l'encodage arithmétique contextuel implique un balayage horizontal de gauche à droite, ligne par ligne, du haut vers le bas. Le décodage arithmétique contextuel implique le même balayage. Le contexte [C(K)] est composé de la valeur booléenne du pixel précédent [P(K-1)] et de certains autres pixels précédents. Il a déjà été dit que la norme MPEG4 définit un contexte pour chaque pixel. La Figure 2 n'illustre qu'un exemple de contexte. Dans tous les cas, au niveau du décodage, le contexte est composé d'un certain ensemble de valeurs booléennes déjà établies.

La Figure 3 illustre un dispositif de traitement de données MPEG4. Le dispositif reçoit un flux de données [DS] codé selon la norme MPEG4 et fournit, en réponse, un flux de données vidéo [VO] destiné à un dispositif d'affichage. Le dispositif comprend un décodeur principal [DEC], un décodeur arithmétique contextuel [ARD], un compositeur d'image [RND], un dispositif de mémoire [MEM] et un contrôleur [CNTRL]. Le décodeur arithmétique contextuel [ARD] comprend un processeur de préparation [PRCA] et un processeur de finition [PRCB]. Le dispositif de mémoire [MEM] comprend un tableau de recherche [LUT] (en anglais: look-up table). Ce tableau comprend les différents contextes possibles et associe à chaque contexte la probabilité lui appartenant selon la norme MPEG4.

Le dispositif de traitement de données MPEG illustré à la Figure 3 fonctionne globalement comme suit. Le décodeur principal [DEC] dérive du flux de données [DS], entre autre, des blocs de 16 fois 16 pixels. L'encodage de forme de certains blocs de 16 fois 16 pixels n'a pas été effectué au moyen d'un encodage arithmétique contextuel. Pour ces blocs de 16 fois 16 pixels, le décodeur principal [DEC] dérive également un bloc de 16 fois 16 valeurs booléennes. En revanche, le décodeur arithmétique contextuel [ARD] dérive des blocs de 16 fois 16 valeurs booléennes pour le décodage de forme des blocs de 16 fois 16 pixels dont l'encodage de forme a été effectué au moyen d'un encodage arithmétique contextuel. Le décodeur principal [DEC] fourni le code arithmétique [AC] à partir duquel le décodeur arithmétique contextuel [ARD] effectue le décodage arithmétique contextuel. Donc, le décodeur principal [DEC] effectue toutes les opérations de décodage sauf le décodage arithmétique contextuel. En effet, le décodeur principal [DEC] sous-traite ce dernier décodage au décodeur arithmétique contextuel [ARD].

Les blocs de 16 fois 16 pixels provenant du décodeur principal [DEC] sont temporairement stockés dans le dispositif de mémoire [MEM]. Les blocs de 16 fois 16 valeurs booléennes provenant du décodeur principal [DEC] ou du décodeur arithmétique contextuel [ARD] sont également stockés temporairement dans le dispositif de mémoire [MEM]. Le décodeur principal [DEC] dérive d'autres informations du flux de données [DS] qui sont utiles pour effectuer d'autres étapes du décodage d'image et délivre finalement les images prêtes à être composées. Ces informations sont également stockées temporairement dans le dispositif de mémoire [MEM]. Le compositeur d'image [RND] compose une image à afficher à partir des différentes données qui sont stockées dans le dispositif de mémoire [MEM]. Une image est typiquement composée de différents objets, par exemple, une maison, un arbre, un ballon. La texture d'un objet est représentée par un ensemble de blocs de 16 fois 16 pixels. La forme d'un objet est représentée par un ensemble de blocs de 16 fois 16 valeurs booléennes.

Il a déjà été dit que le décodeur arithmétique contextuel [ARD] fournit les blocs de 16 fois 16 valeurs booléennes pour les blocs de 16 fois 16 pixels dont l'encodage de forme a été effectué au moyen d'un encodage arithmétique contextuel. Le décodeur arithmétique contextuel [ARD] effectue un décodage arithmétique contextuel au moyen du processeur de préparation [PRCA] et du processeur de finition [PRCB]. Ces deux processeurs fonctionnent en parallèle sous le contrôle du contrôleur [CNTRL]. Le contrôleur [CNTRL] détermine pour quel pixel le processeur de préparation [PRCA] et le processeur de finition [PRCB] effectuent respectivement leurs opérations. Pendant que le processeur de préparation [PRCA] effectue des opérations préparatoires pour déterminer la valeur booléenne appartenant au pixel numéro K, le processeur de finition [PRCB] effectue des opérations finales pour déterminer la valeur booléenne appartenant au pixel numéro K-1, K étant un entier. Les opérations préparatoires comprennent l'établissement de deux contextes possibles et, ensuite, l'établissement de deux probabilités qui, selon la norme, sont associées à ces contextes. Les opérations finales comprennent la sélection d'une des deux probabilités et l'établissement d'une valeur booléenne à partir de la probabilité sélectionnée et du code issu de l'encodage arithmétique contextuel.

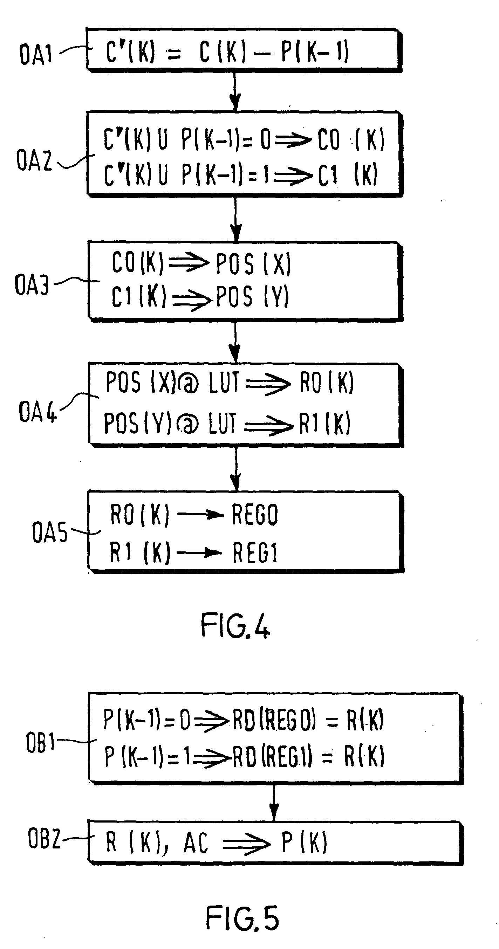

La Figure 4 illustre différentes opérations qu'effectue le processeur de préparation [PRCA]. Une première opération [OA1] consiste à former un contexte partiel [C'(K)] pour le pixel numéro K. Le contexte partiel [C'(K)] est l'ensemble des valeurs booléennes devant être prise en compte selon la norme, à l'exception de la valeur booléenne du pixel précédent [P(K-1)]. Cette valeur booléenne [P(K-1)] n'est pas encore disponible; elle fait l'objet des opérations effectuées en parallèle par le processeur de finition [PRCB]. La formation du contexte partiel [C'(K)] implique des lectures du dispositif de mémoire [MEM] dans lequel les valeurs booléennes déjà obtenues sont stockées.

Une deuxième opération [OA2] consiste à former deux contextes possibles à partir du contexte partiel [C'(K)]. Un premier contexte possible [C0(K)] correspond au contexte partiel [C'(K)] auquel est ajoutée la valeur zéro (0) en tant que valeur booléenne du pixel précédent P(K-1). Un deuxième contexte possible [C1(K)] correspond au contexte partiel [C'(K)] auquel est ajoutée la valeur un (1) en tant que valeur booléenne du pixel précédent P(K-1). Donc, le premier contexte possible [C0(K)] sera le contexte correct pour l'établissement de la valeur booléenne appartenant au pixel courant [P(K)] si la valeur booléenne du pixel précédent [P(K-1)] est zéro (0). En revanche, le deuxième contexte possible [C1(K)] sera le contexte correct si la valeur booléenne du pixel précédent [P(K-1)] est un (1).

Une troisième opération [OA3] consiste à déduire quelle position dans le tableau de recherche [LUT] correspond au premier contexte possible [CO(K)] et quelle position correspond au deuxième contexte possible [C1(K)]. En effet, les contextes possibles sont transformés en adresses. Une telle transformation peut être effectuée, par exemple, au moyen d'un ensemble de circuits logiques.

Une quatrième opération [OA4] consiste à lire les positions concernées du tableau de recherche [LUT]. Ainsi, on obtient deux probabilités possibles: une première probabilité possible [R0(K)] qui, selon la norme, appartient au premier contexte possible [CO(K)], et une deuxième probabilité possible [R1(K)] qui appartient au deuxième contexte possible [CO(K)]. La première probabilité possible [C0(K)] sera la probabilité correcte pour l'établissement de la valeur booléenne appartenant au pixel courant [P(K)] si la valeur booléenne du pixel précédent P(K-1) est zéro (0). En revanche, la deuxième probabilité possible [C1(K)] sera la probabilité correcte si la valeur booléenne du pixel précédent [P(K-1)] est un (1).

Il est avantageux d'implémenter le tableau de recherche [LUT] sous forme de deux demi-tableaux: un demi-tableau qui contient les probabilités correspondant aux contextes dont la valeur booléenne du dernier pixel est égale à zéro (0) et un autre demi-tableau qui contient les probabilités correspondant aux contextes dont la valeur booléenne du dernier pixel est égale à un (1). Une telle implémentation permet que la lecture de la première probabilité possible [R0(K)] et celle de la deuxième probabilité possible [R1(K)] se fassent en parallèle.

Une cinquième opération [OA5] consiste à écrire la première et la deuxième probabilité possibles respectivement dans un premier élément de stockage et un deuxième élément de stockage prédéfinis. Donc, le premier élément de stockage contiendra la probabilité correcte si la valeur booléenne du pixel précédent P(K-1) est zéro (0). En revanche, le deuxième élément de stockage contiendra la probabilité correcte si la valeur booléenne du pixel précédent [P(K-1)] est un (1).

La Figure 5 illustre différentes opérations qu'effectue le processeur de finition [PRCB]. Le processeur de finition [PRCB] est supposé avoir calculé la valeur booléenne du pixel précédent [P(K-1)]. Une première opération [OB1] consiste à lire soit le premier élément de stockage ou le deuxième élément de stockage. Le processeur de finition [PRCB] lit le premier élément de stockage si la valeur booléenne du pixel précédent [P(K-1)] est égale à zéro (0). En revanche, le processeur de finition [PRCB] lit le deuxième élément de stockage si la valeur booléenne du pixel précédent [P(K-1)] est égale à un (1). Ainsi, on obtient la probabilité correcte pour déterminer la valeur booléenne appartenant au pixel courant [P(K)].

Une deuxième opération [OB2] consiste à calculer la valeur booléenne appartenant au pixel courant [P(K)]. Le processeur de finition [PRCB] effectue ce calcul à partir de la probabilité établie par la première opération [OB1] et le code arithmétique pour le bloc de pixels concerné.

Le dispositif de traitement de données MPEG4 décrit en référence aux Figures 2-5 est un exemple d'implémentation des caractéristiques illustrées à la Figure 1. Un résultat d'une étape de traitement [O] illustré à la Figure 1 prend la forme d'une valeur booléenne établie pour un pixel [P] illustré la Figure 2. Un résultat intermédiaire [I] illustré à la Figure 1 prend la forme des deux probabilités possibles [R0(K), R1(K)] illustrées à la Figure 4. Le processeur de préparation [PRCA] illustré à la Figure 3 établit deux probabilités possibles à partir d'un contexte partiel dans lequel il manque, par rapport au contexte à partir duquel une valeur booléenne doit être calculée, la valeur booléenne appartenant au pixel précédent. Le processeur de finition [PRCB] illustré à la Figure 3 établit une valeur booléenne à partir des deux probabilités possibles et la valeur booléenne appartenant au pixel précédent.

La description ci-dessus en référence aux Figures 1 à 5 illustre l'invention plutôt qu'elle ne la limite. Il est évident qu'il existe de nombreuses alternatives qui rentrent dans la portée des revendications ci-jointes. A cet égard, quelques remarques sont faites en conclusion.

Il y a de nombreuses manières pour effectuer une étape de traitement en effectuant une sous-étape de préparation et une sous-étape de finition selon l'invention. A cet égard, le dispositif de traitement MPEG4 décrit en référence aux Figures 2 à 5 a la caractéristique suivante. L'étape de préparation prend en compte tous les résultats nécessaires pour établir un nouveau résultat sauf le résultat de l'étape précédente. Par conséquent, l'étape de finition prend en compte le résultat intermédiaire que fournit l'étape de préparation et le résultat de l'étape précédente. Il est également possible d'implémenter l'invention de la façon suivante. L'étape de préparation ne prend pas en compte plusieurs résultats nécessaires pour établir un nouveau résultat. Par exemple, une autre façon d'effectuer un décodage arithmétique contextuel est comme suit. Un processeur de préparation ne prend pas en compte les valeurs booléennes appartenant au dernier et à l'avant-dernier pixel. Un tel processeur de préparation établit quatre probabilités possibles: une première, une deuxième, une troisième et une quatrième probabilité possible respectivement associées à la possibilité que les valeurs booléennes appartenant au dernier et à l'avant-dernier pixels soient respectivement 00, 01, 10 ou 11. Un processeur de finition sélectionne une probabilité possible à partir des valeurs booléennes réellement établies afin d'établir la valeur booléenne pour le pixel courant.

Il existe de nombreuses manières pour implémenter des fonctions au moyen d'articles physiques (en anglais: items of hardware) ou de logiciels (en anglais: software) ou d'une combinaison des deux. A cet égard, les figures sont très schématiques, chaque figure représentant un mode de réalisation seulement. Donc, bien qu'une figure montre différentes fonctions sous forme de blocs séparés, ceci n'exclut pas du tout qu'un seul article physique ou logiciel effectue plusieurs fonctions. Ceci n'exclut nullement qu'une fonction puisse être effectuée par un ensemble d'articles physiques ou de logiciels.

Par exemple, le dispositif de traitement MPEG4 illustré à la Figure 3 comprend différents blocs qui, en combinaison, effectuent un décodage arithmétique contextuel. En principe, il est possible d'implémenter ces blocs au moyen d'un circuit d'ordinateur convenablement programmé. Un jeu d'instructions contenu dans une mémoire de programmation peut provoquer le circuit d'ordinateur à effectuer les différentes opérations décrites précédemment en référence aux Figures 2-5. Le jeu d'instructions peut être chargé dans la mémoire de programmation par la lecture d'un support de données comme, par exemple, un disque qui contient le jeu d'instructions. La lecture peut s'effecteur par l'intermédiaire d'un réseau de communication comme, par exemple, le réseau Internet. Dans cas, un fournisseur de service (en anglais: service provider) mettra le jeu d'instructions à la disposition des intéressées.

Aucun signe de référence entre parenthèses dans une revendication ne doit être interprété de façon limitative. Le mot "comprenant" n'exclut pas la présence d'autres éléments ou étapes listés dans une revendication. Le mot "un" ou "une" précédant un élément ou une étape n'exclut pas la présence d'une pluralité de ces éléments ou ces étapes.

## Revendications

1. Procédé de traitement de données au moyen d'un processeur en une série temporelle d'étapes de traitement, une étape de traitement générant un résultat à partir d'un ensemble de résultats de certaines étapes de traitement précédentes, le procédé étant **caractérisée en ce qu'**une étape de traitement est effectuée en deux sous-étapes :
- une sous-étape de préparation dans laquelle un résultat intermédiaire est établi à partir d'un ensemble incomplet de résultats dans lequel il manque, par rapport à l'ensemble de résultats à partir duquel le résultat doit être calculé, au moins le résultat de l'étape de traitement précédente la plus proche ; et
- une sous-étape de finition dans laquelle le résultat est établi à partir du résultat intermédiaire et du résultat de l'étape de traitement précédente la plus proche et des autres résultats qui manquaient dans l'ensemble incomplet de résultats, s'il y en a.

2. Dispositif de traitement de données pour effectuer une série temporelle d'étapes de traitement, une étape de traitement générant un résultat à partir d'un ensemble de résultats de certaines étapes de traitement précédentes, le dispositif étant **caractérisé en ce qu'**il est agencé pour effectuer une étape de traitement au moyen de deux processeurs :
- un processeur de préparation pour établir un résultat intermédiaire à partir d'un ensemble incomplet de résultats dans lequel il manque, par rapport à l'ensemble de résultats à partir duquel le résultat doit être calculé, au moins le résultat de l'étape de traitement précédente la plus proche ; et
- un processeur de finition pour établir le résultat à partir du résultat intermédiaire et du résultat de l'étape de traitement précédente la plus proche et des autres résultats qui manquaient dans l'ensemble incomplet de résultats, s'il y en a.

3. Produit « programme d'ordinateur » pour un dispositif de traitement de données, le produit « programme d'ordinateur » comprenant un jeu d'instructions qui, quand il est chargé dans le dispositif de traitement de données, amène celui-ci à effectuer une série temporelle d'étapes de traitement, une étape de traitement générant un résultat à partir d'un ensemble de résultats de certaines étapes de traitement précédentes, une étape de traitement étant effectuée en deux sous-étapes :
- une sous-étape de préparation dans laquelle un résultat intermédiaire est établi à partir d'un ensemble incomplet de résultats dans lequel il manque, par rapport à l'ensemble de résultats à partir duquel le résultat doit être calculé, au moins le résultat de l'étape de traitement précédente la plus proche ; et
- une sous-étape de finition dans laquelle le résultat est établi à partir du résultat intermédiaire et du résultat de l'étape de traitement précédente la plus proche et des autres résultats qui manquaient dans l'ensemble incomplet de résultats, s'il y en a.

4. Procédé de décodage de forme en une série temporelle d'étapes de décodage, une étape de décodage générant une valeur booléenne à partir d'un ensemble de valeurs booléennes de certaines étapes de décodage précédentes, le procédé étant **caractérisée en ce qu'**une étape de décodage est effectuée en deux sous-étapes :
- une sous-étape de préparation dans laquelle un jeu de probabilités possibles est établi à partir d'un ensemble incomplet de valeurs booléennes dans lequel il manque, par rapport à l'ensemble de valeurs booléennes à partir duquel la valeur booléenne doit être calculée, au moins la valeur booléenne de l'étape de décodage précédente la plus proche et
- une sous-étape de finition dans laquelle la valeur booléenne est établie à partir du jeu de probabilités possibles et de la valeur booléenne de l'étape de décodage précédente la plus proche et des autres valeurs booléennes qui manquaient dans l'ensemble incomplet de valeurs booléennes, s'il y en a.
